# FASCICULE DE BREVET EUROPEEN

(11) **EP 3 702 797 B1**
(45) Date de publication et mention de la délivrance du brevet: **27.04.2022**
(21) Numéro de dépôt: 20158624.5
(22) Date de dépôt: 20.02.2020
(51) Int. Cl.: G01R 33/26

(54) **MAGNÉTOMÈTRE SCALAIRE ISOTROPE ET TOUT OPTIQUE**
ISOTROPES, SKALARES UND REIN OPTISCHES MAGNETOMETER
ALL-OPTICAL ISOTROPIC SCALAR MAGNETOMETER

(30) Priorité: 28.02.2019 FR 1902087
(43) Date de publication de la demande: 02.09.2020
(73) Titulaire: Commissariat à l'énergie atomique et aux énergies alternatives, 75015 Paris (FR)
(72) Inventeur: LIEB, Gaëtan, 38054 Grenoble Cedex 09 (FR); PALACIOS LALOY, Agustin, 38054 Grenoble Cedex 09 (FR)
(74) Mandataire: Brevalex

(56) Documents cités:
- EP-A1- 3 115 799
- ZHIVUN ELENA ET AL: "Alkali-vapor magnetic resonance driven by fictitious radiofrequency fields", APPLIED PHYSICS LETTERS, A I P PUBLISHING LLC, US, vol. 105, no. 19, 10 novembre 2014 (2014-11-10), XP012191880, ISSN: 0003-6951, DOI: 10.1063/1.4902028 [extrait le 1901-01-01]
- LIN ZAISHENG ET AL: "All-optical 4He magnetometer driven by fictitious oscillating magnetic field", 2017 CONFERENCE ON LASERS AND ELECTRO-OPTICS (CLEO), THE OPTICAL SOCIETY, 14 mai 2017 (2017-05-14), pages 1-2, XP033237691, DOI: 10.1364/CLEO_AT.2017.AW1B.7
- LIEB G ET AL: "All-optical isotropic scalar4He magnetometer based on atomic alignment", REVIEW OF SCIENTIFIC INSTRUMENTS, AIP, MELVILLE, NY, US, vol. 90, no. 7, 8 juillet 2019 (2019-07-08), XP012239033, ISSN: 0034-6748, DOI: 10.1063/1.5093533 [extrait le 2019-07-08]

## Description

### DOMAINE TECHNIQUE

Le domaine de l'invention est celui des magnétomètres scalaires à pompage optique. L'invention concerne plus particulièrement une configuration de magnétomètre dite isotrope pour laquelle les mesures ne dépendent pas de l'orientation relative du magnétomètre par rapport au champ magnétique à mesurer.

### TECHNIQUE ANTÉRIEURE

Les magnétomètres à pompage optique utilisent des gaz atomiques confinés dans une cellule, typiquement de l'hélium métastable ou des gaz d'alcalins, en tant qu'élément sensible. Ces magnétomètres, qui peuvent prendre différentes configurations, permettent de remonter au champ magnétique en exploitant les trois processus suivants qui ont lieu de façon soit séquentielle soit concomitante :
L'utilisation de sources de lumière polarisée, typiquement des lasers, permet de préparer des états atomiques caractérisés par une certaine orientation ou alignement de leurs spins. Ce processus reçoit le nom de « pompage optique » dans le domaine.

Ces états atomiques évoluent sous l'effet du champ magnétique, notamment sous l'effet Zeeman, qui correspond à des décalages des niveaux d'énergie en fonction du champ magnétique auquel les atomes sont soumis.

Les propriétés optiques du milieu atomique subissent alors des modifications qui dépendent de l'état des atomes. On peut ainsi par une mesure optique, par exemple par une mesure d'absorption optique, remonter au décalage Zeeman subi, et en déduire une mesure du champ magnétique dans lequel est plongée la cellule.

Selon les différentes configurations possibles des magnétomètres à pompage optique existants, on distingue une mesure du module, aussi appelée norme, du champ magnétique pour les magnétomètres scalaires, ou une détermination des différentes composantes du champ magnétique pour les magnétomètres vectoriels.

Un configuration simple d'un magnétomètre scalaire exploite un faisceau de pompe polarisé linéairement de manière à induire une polarisation d'alignement sur les atomes d'un gaz atomique et un assemblage de bobines venant générer un champ magnétique radiofréquence (champ RF) qui permet d'exciter la résonance magnétique. Si on fait varier la fréquence du champ RF autour de la fréquence de Larmor, on observe sur un signal de photodétection des signaux à la fréquence nulle (signal de résonance LA0), autour de la fréquence de Larmor (signal de résonance LA1) et autour du double de la fréquence de Larmor (signal de résonance LA2). L'amplitude de ces signaux de résonance qui servent à réaliser la mesure scalaire d'un champ ambiant est fonction de l'orientation du vecteur polarisation du faisceau de pompe par rapport au champ ambiant. Il en résulte que la sensibilité du magnétomètre n'est pas constante vis-à-vis de ces paramètres géométriques. Cette anisotropie spatiale de l'amplitude du signal de mesure présente notamment des « angles morts », ou zones d'ombre, pour lesquels le signal de mesure disparaît de sorte que la mesure du champ magnétique devient impossible (c'est le cas à un angle de 54.7° entre le champ magnétique à mesurer et la polarisation de la lumière pour l'hélium 4 par exemple).

Cette perte du signal n'est pas désirable, et différentes configurations pour s'en affranchir ont été proposées. Il a notamment été proposé d'utiliser plusieurs magnétomètres disposés de telle manière que leurs zones d'ombre soient complémentaires. Cette solution est cependant encombrante et sensible aux gradients.

Une autre solution pour assurer l'isotropie est décrite dans le brevet EP 0 579 537 B1. Elle consiste à asservir la polarisation de la lumière en la tournant avec un polariseur disposé sur un moteur amagnétique de telle manière à ce qu'elle se trouve toujours à 90° du champ magnétique local. Cette condition peut être stabilisée en utilisant le signal LA1 qui s'annule et change de signe lorsque l'angle entre le champ magnétique et la polarisation de la lumière est à 90°. Les signaux LA2 et LA0 ne s'annulent pas à 90° et peuvent alors être utilisés pour mesurer le champ.

Dans ces deux configurations, le champ RF est généré au moyen de bobines. Or ces bobines contribuent à l'encombrement du magnétomètre et peuvent induire de la diaphonie entre magnétomètres voisins, par exemple dans le cas où plusieurs magnétomètres sont utilisés pour constituer un gradiomètre.

Pour s'affranchir des bobines, plusieurs solutions sont possibles. L'effet connu comme « light-shift » ou « AC-Stark shift », fourni au moyen d'un faisceau de lumière polarisé circulairement et non accordé à une transition atomique, permet ainsi de créer l'équivalent d'un champ magnétique dans le gaz sans utiliser de bobines (on parle alors de champ magnétique fictif). La modulation de l'intensité du faisceau de lumière permet de créer l'équivalent d'un champ RF. Cette technique est notamment exposée dans l'article de E. Zhivun et al. « Alkali-vapor magnetic resonance driven by fictitious radiofrequency fields », Applied Physics Letters, vol. 105, n° 19, p. 192406, nov. 2014. Ce magnétomètre présente néanmoins des zones d'ombre et pour obtenir un fonctionnement isotrope, il faut alors utiliser deux faisceaux de « light-shift » modulés en intensité, perpendiculaires l'un à l'autre et perpendiculaires au faisceau de pompe pour créer l'équivalent d'un champ RF dont l'orientation reste colinéaire avec la polarisation du faisceau de pompe. Cette solution requiert donc trois accès optiques pour assurer l'isotropie de la mesure ce qui s'avère encombrant.

Un autre type de configuration permettant de s'affranchir des bobines est basée sur une modulation de l'intensité, de la longueur d'onde ou de la polarisation du faisceau de pompe qui permet de générer une résonance optique. Toutefois cette configuration ne permet pas d'utiliser le schéma d'asservissement du brevet EP 0 579 537 B1 présenté cidessus pour assurer l'isotropie du capteur. En effet les signaux de résonance ne présentent pas les comportements décrits plus haut, à savoir l'existence d'un angle où l'un des signaux change de signe (de manière à pouvoir asservir la polarisation) tandis qu'un autre signal reste non nul (de manière à pouvoir mesurer le champ magnétique).

Le brevet EP 3 115 799 B1 de la Demanderesse décrit une architecture qui combine deux modulations du faisceau de pompe pour obtenir un point de fonctionnement qui présente un changement de signe du signal LA1 permettant un asservissement de l'angle de polarisation, tout en gardant à ce même angle un signal LA2 non nul qui permet la mesure magnétique. Cependant l'angle auquel cette condition est satisfaite varie en fonction de plusieurs paramètres expérimentaux et cette architecture présente en général un signal à bruit non optimal car le changement de signe du signal LA1 ne correspond pas au maximum du signal LA2.

### EXPOSÉ DE L'INVENTION

L'invention a pour objectif de proposer une architecture de magnétomètre isotrope qui soit compacte et qui offre une bonne sensibilité de mesure. A cet effet, l'invention concerne un magnétomètre à pompage optique destiné à la mesure d'un champ magnétique ambiant, comprenant :
des moyens pour éclairer une cellule remplie d'un gaz atomique avec:
un faisceau de pompe accordé sur une raie de transition atomique et polarisé linéairement selon une direction de polarisation, et
un faisceau d'effet Stark alternatif décalé de la raie de transition atomique et polarisé circulairement,
un premier modulateur configuré pour moduler le faisceau de pompe au moyen d'une première fréquence de modulation,
un rotateur de polarisation configuré pour tourner la direction de polarisation du faisceau de pompe, un deuxième modulateur configuré pour moduler le faisceau d'effet Stark alternatif au moyen d'une deuxième fréquence de modulation,
un premier circuit d'asservissement agissant sur le rotateur de polarisation pour maintenir un angle constant entre la direction de polarisation du faisceau de pompe et le champ magnétique ambiant,
un deuxième circuit d'asservissement agissant sur le premier et le deuxième modulateur pour maintenir la première et la deuxième fréquence de modulation à la fréquence de Larmor du gaz atomique ou à l'une de ses harmoniques.

Certains aspects préférés mais non limitatifs de ce magnétomètre sont les suivants :
le faisceau de pompe et le faisceau d'effet Stark alternatif se propagent colinéairement dans la cellule ;
lesdits moyens pour éclairer la cellule comprennent un assemblage de fibres à maintien de polarisation linéaire dans lequel le faisceau de pompe et le faisceau d'effet Stark alternatif sont injectés et un collimateur en sortie dudit assemblage pour collimater le faisceau de pompe et le faisceau d'effet Stark alternatif en direction de la cellule ;
le faisceau de pompe et le faisceau d'effet Stark alternatif ont dans ledit assemblage des directions de propagation parallèles et des directions de polarisation faisant entre elles un angle de 45° ;
lesdits moyens pour éclairer la cellule comprennent en outre une lame quart d'onde interposée entre le collimateur et la cellule et dont les axes neutres sont à 45° de la direction de polarisation linéaire du faisceau d'effet Stark alternatif dans ledit assemblage ;
le rotateur de polarisation est intercalé entre la lame quart d'onde et la cellule ;
le faisceau de pompe et le faisceau d'effet Stark alternatif se propagent en sens inverse dans la cellule ;
le faisceau de pompe et le faisceau d'effet Stark alternatif ont dans la cellule des directions de propagation faisant entre elles un angle non nul inférieur à 3° ;
le premier modulateur effectue une modulation en intensité ou en polarisation du faisceau de pompe et la première fréquence de modulation est asservie au double de la fréquence de Larmor ;
le premier modulateur effectue une modulation en longueur d'onde du faisceau de pompe ;
le faisceau de pompe est accordé au centre de la raie de transition atomique et la première fréquence de modulation est asservie à la fréquence de Larmor ;
le faisceau de pompe est accordé à mi-hauteur de la raie de transition atomique et la première fréquence de modulation est asservie au double de la fréquence de Larmor ;
le deuxième modulateur effectue une modulation en intensité du faisceau d'effet Stark alternatif et la deuxième fréquence de modulation est asservie à la fréquence de Larmor ;
le premier circuit d'asservissement réalise une détection synchrone à la fréquence de Larmor et le deuxième circuit d'asservissement réalise une détection synchrone au double de la fréquence de Larmor.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
La figure 1 est un schéma d'un magnétomètre selon un premier mode de réalisation possible de l'invention.
La figure 2 est un schéma illustrant la géométrie des faisceaux par rapport au champ magnétique à mesurer.
La figure 3 représente l'amplitude de la composante de résonance à la fréquence de Larmor en fonction de l'angle β entre la polarisation du faisceau de pompe et le champ magnétique.
La figure 4 représente l'amplitude de la composante de résonance au double de la fréquence de Larmor en fonction de l'angle β entre la polarisation du faisceau de pompe et le champ magnétique.
La figure 5 est un schéma d'un magnétomètre selon un deuxième mode de réalisation possible de l'invention.

### DESCRIPTION DÉTAILLÉE

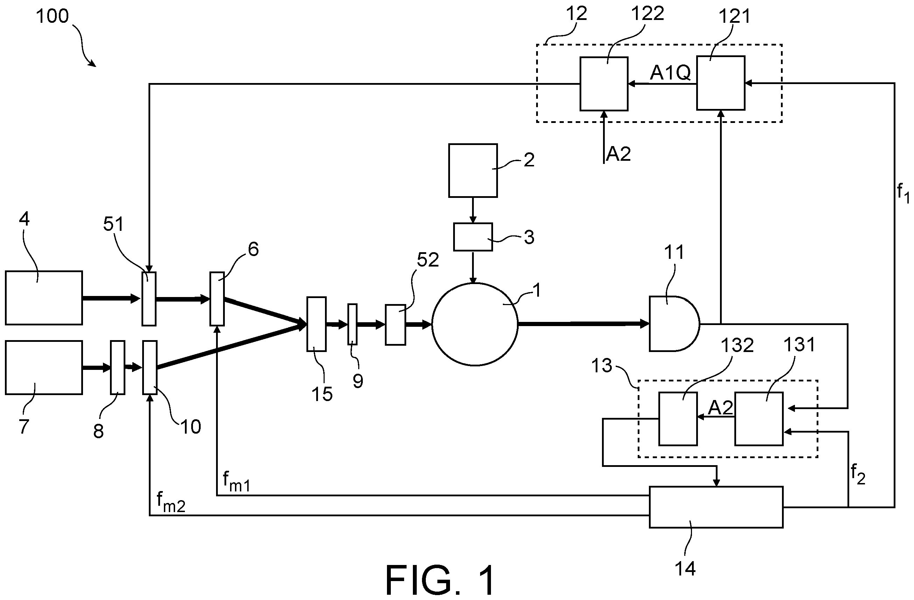

En référence à la figure 1, l'invention porte sur un magnétomètre à pompage optique 100. Le magnétomètre comprend une cellule 1 remplie d'un gaz atomique, par exemple de l'hélium-4 ou un gaz alcalin, soumis à un champ magnétique ambiant. Le magnétomètre comprend des moyens pour éclairer la cellule avec un faisceau de pompe et un faisceau d'effet Stark alternatif. Ces faisceaux se propagent de préférence colinéairement ou quasi-colinéairement (avec un angle typiquement d'au plus 3° entre eux) dans la cellule et ne requièrent donc qu'un seul accès optique.

Dans le cas où l'élément sensible est l'hélium-4, le magnétomètre comporte par ailleurs un système de décharge haute fréquence (HF), comprenant un générateur HF 2 et des bobines de surtension 3, pour amener les atomes du gaz atomique dans un état énergisé où ils sont aptes à subir la transition atomique lorsqu'ils sont éclairés par le faisceau de pompe, typiquement dans l'état métastable 2³S₁.

Le faisceau de pompe est accordé sur une raie de transition atomique, par exemple sur la raie Do à 1083 nm dans le cas de l'hélium-4. Il permet de réaliser un pompage optique du niveau métastable 2³S₁ au niveau excité 2³P₀.

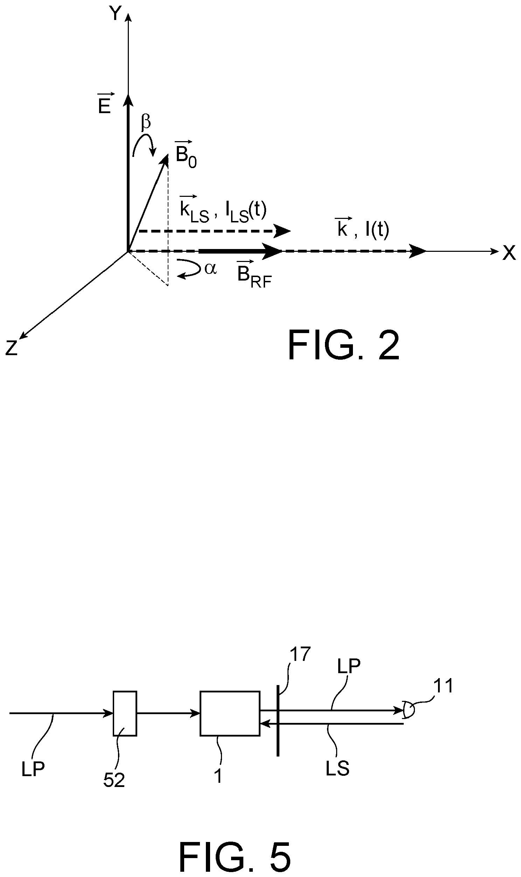

Le faisceau de pompe est polarisé linéairement. Dans le repère XYZ de la figure 2, le faisceau de pompe se propage selon une direction de propagation *̅k̅*̅ orientée le long de l'axe X. Sa direction de polarisation *̅E̅*̅, orthogonale à sa direction de propagation, est dans le plan YZ. Cette direction de polarisation *̅E̅*̅ forme un angle β avec le champ magnétique ambiant *̅B̅*̅₀̅. Le projection du champ magnétique ambiant *̅B̅*̅₀̅ dans le plan XZ forme un angle α avec la direction de propagation *̅k̅*̅.

Le faisceau de pompe peut être émis par une première source laser 4 et être polarisé linéairement au moyen d'un polariseur rectiligne 51 intercalé entre la source laser 4 et la cellule 1 ou directement intégré à la source laser 4.

Dans le cadre de l'invention, le faisceau de pompe est modulé par un premier modulateur 6 au moyen d'une première fréquence de modulation fₘ₁ qui correspond à la fréquence de Larmor du gaz atomique ou à l'une de ses harmoniques. Le faisceau de pompe peut être modulé en intensité, en polarisation ou encore en longueur d'onde.

Le premier modulateur 6 peut notamment effectuer une modulation en intensité ou en polarisation du faisceau de pompe, la première fréquence de modulation étant asservie au double de la fréquence de Larmor.

Le premier modulateur 6 peut alternativement effectuer une modulation en longueur d'onde du faisceau de pompe. Lorsque le faisceau de pompe est accordé au centre de la raie de transition atomique, la première fréquence de modulation est asservie à la fréquence de Larmor. Lorsque le faisceau de pompe est accordé sur le flanc de la raie de transition atomique, par exemple à la mi-hauteur de la raie de transition atomique, la première fréquence de modulation est asservie au double de la fréquence de Larmor.

Une modulation en intensité peut être par exemple réalisée à l'aide d'un modulateur acousto-optique. Une modulation en polarisation peut par exemple être réalisée à l'aide d'un modulateur électro-optique. Une modulation en longueur d'onde peut par exemple être réalisée en venant superposer un courant de modulation au courant d'alimentation du laser.

L'invention exploite par ailleurs un faisceau dit d'effet Stark alternatif dont le rôle est de générer un champ magnétique RF fictif dans la cellule. Ce faisceau d'effet Stark alternatif est décalé (i.e. non accordé) de la raie de transition atomique et polarisé circulairement. Il peut être émis par une deuxième source laser 7 et être polarisé circulairement par l'association d'un polariseur rectiligne 8 (éventuellement directement intégré à la source laser 7) et d'une lame quart d'onde 9. Il est modulé par un deuxième modulateur 10 au moyen d'une deuxième fréquence de modulation fₘ₂, typiquement en intensité, la deuxième fréquence de modulation étant asservie à la fréquence de Larmor.

Un rotateur de polarisation 52, par exemple un rotateur à cristaux liquides, est interposé entre la lame quart d'onde 9 et la cellule 1. Le rotateur 52 permet d'orienter la polarisation du faisceau de pompe dans une direction quelconque orthogonalement à sa direction de propagation de façon à maintenir constant l'angle β entre la direction de polarisation du faisceau pompe et la direction du champ magnétique et ceci quelle que soit l'orientation du capteur. Il maintient invariantes les polarisations circulaires qui le traversent, notamment la polarisation circulaire du faisceau d'effet Stark alternatif.

Le magnétomètre comprend par ailleurs un synthétiseur de fréquence 14 qui génère les fréquences de modulation fₘ₁ et f_{m2.} Il comprend par ailleurs un photodétecteur 11 qui reçoit la lumière ayant traversé la cellule et fournit un signal électrique à un premier circuit d'asservissement 12 et à un deuxième circuit d'asservissement 13. Le premier circuit d'asservissement 12 agit sur le rotateur de polarisation 52 pour maintenir constant l'angle β entre la direction de polarisation du faisceau de pompe et le champ magnétique ambiant. Le deuxième circuit d'asservissement 13 agit sur le premier et le deuxième modulateur 6, 10 pour maintenir la première et la deuxième fréquence de modulation à la fréquence de Larmor du gaz atomique ou à l'une de ses harmoniques. Ces circuits d'asservissement 12, 13 peuvent notamment être réalisés conformément au brevet FR2713347-B1.

Le premier circuit d'asservissement 12 comprend un circuit de détection 121 qui reçoit le signal issu du photodétecteur 11 et effectue une détection synchrone à une première fréquence de référence f₁ fournie par le synthétiseur de fréquence 14 pour détecter la composante A1Q qui sert de signal d'erreur pour piloter le rotateur de polarisation afin que l'angle β reste constant, avec de préférence β=90°.

Le deuxième circuit d'asservissement 13 comprend un circuit de détection 131 qui reçoit le signal issu du photodétecteur 11 et effectue une détection synchrone à une deuxième fréquence de référence f₂ fournie par le synthétiseur de fréquence 14 pour détecter la composante A2 au double de la fréquence de Larmor. Le circuit de détection 131 peut être suivi d'un intégrateur 312. Le deuxième circuit d'asservissement 13 fournit en sortie une valeur de consigne qui permet de piloter la génération des fréquences de modulation fₘ₁, fₘ₂ et des fréquences de référence f₁, f₂ par le synthétiseur de fréquence 14 de manière à ce qu'elles s'établissent selon f₁ = fₘ₂ = F_{L,} f₂ = 2^{∗}F_{L} et fₘ₁ = F_{L} ou 2^{∗}F_{L} selon la modulation adoptée pour le faisceau de pompe, où F_{L} désigne la fréquence de Larmor du gaz atomique. Cette fréquence, directement reliée au champ magnétique *B*₀ par le rapport gyromagnétique γ selon F_{L}=γB₀, peut être mesurée au moyen d'un fréquencemètre.

Le premier circuit d'asservissement 12 peut venir vérifier au moyen d'un module de vérification 122 que la condition d'annulation de la composante A1Q s'opère bien pour une valeur non nulle de la composante A2.

Reprenant l'exemple de la figure 2, le faisceau de pompe polarisé linéairement peut se propager selon l'axe X et avoir son intensité modulée selon *I*(*t*) = *I*₀(1 + cos(2*ωt*)) à une fréquence double de la fréquence de Larmor F_{L}=ω/2π. Le faisceau d'effet Stark alternatif se propage dans la cellule selon le même axe X. Il est polarisé circulairement, son intensité est modulée en *I_{LS}*(*t*) = *I*_{0*LS*}(1 + cos(*ωt*)) à la fréquence de Larmor. Le faisceau d'effet Stark alternatif permet de générer un champ RF fictif *̅B̅_̅{̅R̅F̅}̅*̅ orienté selon l'axe X.

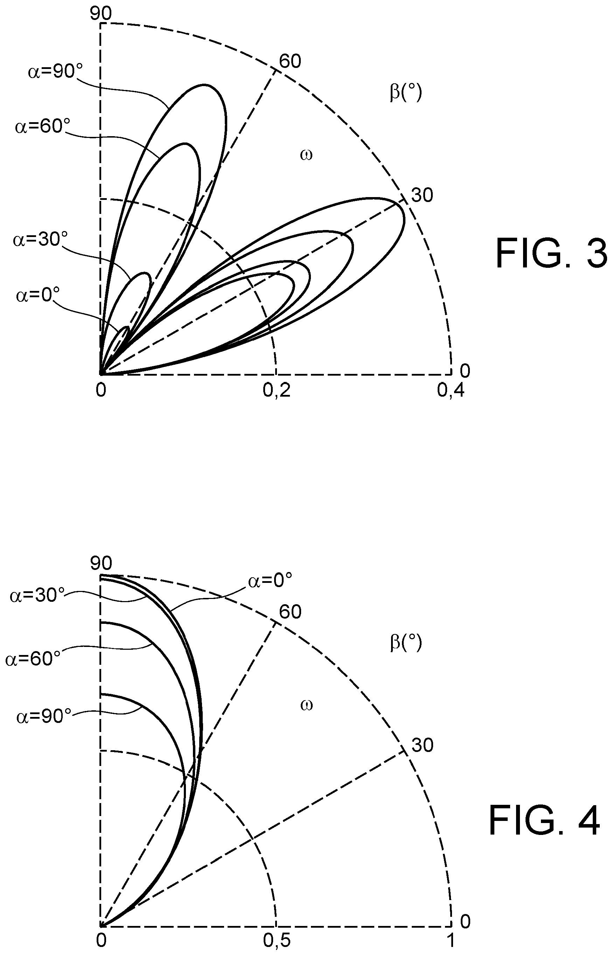

On a représenté sur la figure 3 l'amplitude en coordonnées polaires de la composante A1Q à la fréquence de Larmor et sur la figure 4 l'amplitude en coordonnées polaires de la composante A2 au double de la fréquence de Larmor, en fonction de l'angle β. On constate de la figure 3 qu'à *β* =90° , les signaux détectés à *ω* s'annulent et ont une des composantes qui change de signe au passage de 90°. Et on constate de la figure 4 que les signaux détectés à 2*ω* sont non nuls à *β* =90° et présentent de plus une amplitude maximum à cet angle. L'invention rend donc possible la réalisation d'un magnétomètre tout optique et qui présente un point auquel il est possible de s'asservir (*β* =90°) pour assurer l'isotropie tout en assurant une résolution maximale.

Dans un premier mode de réalisation représenté schématiquement sur la figure 1, lesdits moyens pour éclairer la cellule comprennent un assemblage de fibres à maintien de polarisation linéaire 15 dans lequel le faisceau de pompe et le faisceau d'effet Stark alternatif sont injectés et un collimateur en sortie dudit assemblage pour collimater le faisceau de pompe et le faisceau d'effet Stark alternatif en direction de la cellule.

Dans un assemblage de fibres, une extrémité de chacune des fibres est mise à nu et est assemblée avec les extrémités des autres fibres dans une férule, par exemple une pièce à rainures en forme de V. Ainsi les directions de propagation de tous les faisceaux sont fixées. En sortie de l'assemblage, les faisceaux peuvent être collimatés par une lentille commune (ce qui est possible étant donné le très faible écart entre les fibres dans l'assemblage de fibres, typiquement 100 µm) pour recouvrir toute la cellule

Les fibres étant à maintien de polarisation, des directions de polarisations relatives peuvent être fixées. On peut notamment prévoir que dans ledit assemblage le faisceau de pompe et le faisceau d'effet Stark alternatif ont des directions de propagation parallèles et des directions de polarisation faisant entre elles un angle de 45°. Dans un tel cas de figure, les axes neutres de lame quart d'onde 9 interposée entre le collimateur et la cellule sont à 45° de la direction de polarisation linéaire du faisceau d'effet Stark alternatif dans ledit assemblage. Le faisceau d'effet Stark alternatif est ainsi polarisé circulairement alors que le faisceau de pompe, dont la direction de polarisation est selon l'un des axes neutres de la lame quart d'onde, reste polarisé linéairement.

Dans un deuxième mode de réalisation représenté schématiquement sur la figure 5, les faisceaux de pompe et d'effet Stark alternatif se propagent en sens inverse dans la cellule. De telle manière, seul le faisceau de pompe est photodétecté et le rapport signal à bruit est accru.

Dans ce deuxième mode de réalisation, le faisceau de pompe FP modulé et polarisé linéairement est injecté dans une fibre à maintien de polarisation linéaire. Un collimateur est agencé en sortie de ladite fibre pour collimater le faisceau de pompe en direction du rotateur de polarisation 52 en amont de la cellule 1. Le faisceau de pompe en sortie de la cellule est collecté par le photodétecteur 11.

Le faisceau d'effet Stark alternatif LS est également injecté dans une fibre à maintien de polarisation linéaire. Un collimateur est agencé en sortie de ladite fibre pour collimater le faisceau d'effet Stark alternatif en direction d'une lame quart d'onde 17 ici agencée en aval de la cellule.

Le faisceau de pompe et le faisceau d'effet Stark alternatif peuvent avoir dans la cellule des directions de propagation faisant entre elles un angle non nul, de préférence un angle inférieur à 3°. Cela permet d'éviter que le faisceau d'effet Stark alternatif ne soit collecté, après avoir traversé la cellule, par le collimateur équipant la fibre dans laquelle le faisceau de pompe est injecté et ne vienne endommager le laser qui génère le faisceau de pompe.

## Revendications

1. Magnétomètre à pompage optique (100) destiné à la mesure d'un champ magnétique ambiant, comprenant :
des moyens pour éclairer une cellule remplie d'un gaz atomique avec :
un faisceau de pompe (LP) accordé sur une raie de transition atomique et polarisé linéairement selon une direction de polarisation, et
un faisceau d'effet Stark alternatif (LS) décalé de la raie de transition atomique et polarisé circulairement,
un premier modulateur (6) configuré pour moduler le faisceau de pompe au moyen d'une première fréquence de modulation (fₘ₁),
un rotateur de polarisation (52) configuré pour tourner la direction de polarisation du faisceau de pompe,
un deuxième modulateur (10) configuré pour moduler le faisceau d'effet Stark alternatif au moyen d'une deuxième fréquence de modulation (fₘ₂),
un premier circuit d'asservissement (12) agissant sur le rotateur de polarisation (52) pour maintenir un angle constant (β) entre la direction de polarisation du faisceau de pompe et le champ magnétique ambiant,
un deuxième circuit d'asservissement (13) agissant sur le premier et le deuxième modulateur pour maintenir la première et la deuxième fréquence de modulation à la fréquence de Larmor du gaz atomique ou à l'une de ses harmoniques.

2. Magnétomètre selon la revendication 1, dans lequel le faisceau de pompe et le faisceau d'effet Stark alternatif se propagent colinéairement dans la cellule.

3. Magnétomètre selon la revendication 2, dans lequel lesdits moyens pour éclairer la cellule comprennent un assemblage de fibres à maintien de polarisation linéaire (15) dans lequel le faisceau de pompe et le faisceau d'effet Stark alternatif sont injectés et un collimateur en sortie dudit assemblage pour collimater le faisceau de pompe et le faisceau d'effet Stark alternatif en direction de la cellule.

4. Magnétomètre selon la revendication 3, dans lequel le faisceau de pompe et le faisceau d'effet Stark alternatif ont dans ledit assemblage des directions de propagation parallèles et des directions de polarisation faisant entre elles un angle de 45°.

5. Magnétomètre selon la revendication 4, dans lequel lesdits moyens pour éclairer la cellule comprennent en outre une lame quart d'onde (9) interposée entre le collimateur et la cellule et dont les axes neutres sont à 45° de la direction de polarisation linéaire du faisceau d'effet Stark alternatif dans ledit assemblage.

6. Magnétomètre selon la revendication 5, dans lequel le rotateur de polarisation (52) est intercalé entre la lame quart d'onde (9) et la cellule (1).

7. Magnétomètre selon la revendication 1, dans lequel le faisceau de pompe et le faisceau d'effet Stark alternatif se propagent en sens inverse dans la cellule.

8. Magnétomètre selon la revendication 7, dans lequel le faisceau de pompe et le faisceau d'effet Stark alternatif ont dans la cellule des directions de propagation faisant entre elles un angle non nul inférieur à 3°.

9. Magnétomètre selon l'une des revendications 1 à 8, dans lequel le premier modulateur (6) est configuré pour effectuer une modulation en intensité ou en polarisation du faisceau de pompe et la première fréquence de modulation (fₘ₁) est asservie au double de la fréquence de Larmor.

10. Magnétomètre selon l'une des revendications 1 à 8, dans lequel le premier modulateur (6) est configuré pour effectuer une modulation en longueur d'onde du faisceau de pompe.

11. Magnétomètre selon la revendication 10, dans lequel le faisceau de pompe est accordé au centre de la raie de transition atomique et la première fréquence de modulation (fₘ₁) est asservie à la fréquence de Larmor.

12. Magnétomètre selon la revendication 10, dans lequel le faisceau de pompe est accordé à mi-hauteur de la raie de transition atomique et la première fréquence de modulation (fₘ₁) est asservie au double de la fréquence de Larmor.

13. Magnétomètre selon l'une des revendications 1 à 12, dans lequel le deuxième modulateur (10) est configuré pour effectuer une modulation en intensité du faisceau d'effet Stark alternatif et la deuxième fréquence de modulation (fₘ₂) est asservie à la fréquence de Larmor.

14. Magnétomètre selon l'une des revendications 1 à 13, dans lequel le premier circuit d'asservissement (12) est configuré pour réaliser une détection synchrone à la fréquence de Larmor et le deuxième circuit d'asservissement (13) est configuré pour réaliser une détection synchrone au double de la fréquence de Larmor.

## Patentansprüche

1. Optisch gepumptes Magnetometer (100), bestimmt zur Messung eines umgebenden Magnetfelds, umfassend:
Mittel zum Beleuchten einer mit einem Atomgas gefüllten Zelle mit:
einem Pumpenstrahlenbündel (LP), eingestellt auf eine Atomübergangslinie und gemäß einer Polarisationsrichtung linear polarisiert, und
einem Strahlenbündel mit dynamischem Stark-Effekt (LS), von der Atomübergangslinie versetzt und zirkular polarisiert,
einem ersten Modulator (6), konfiguriert zum Modulieren des Pumpenstrahlenbündels mittels einer ersten Modulationsfrequenz (fₘ₁),
einem Polarisationsrotator (52) zum Drehen der Polarisationsrichtung des Pumpenstrahlenbündels,
einem zweiten Modulator (10), konfiguriert zum Modulieren des Strahlenbündels mit dynamischem Stark-Effekt mittels einer zweiten Modulationsfrequenz (fₘ₂),
einem ersten Regelschaltkreis (12), der zum Aufrechterhalten eines konstanten Winkels (β) zwischen der Polarisationsrichtung des Pumpenstrahlenbündels und dem umgebenden Magnetfeld auf den Polarisationsrotator (52) wirkt,
einem zweiten Regelschaltkreis (13), der zum Aufrechterhalten der ersten und der zweiten Modulationsfrequenz bei der Larmor-Frequenz des Atomgases oder einer seiner Oberschwingungen auf den ersten und den zweiten Modulator wirkt.

2. Magnetometer nach Anspruch 1, wobei das Pumpenstrahlenbündel und das Strahlenbündel mit dynamischem Stark-Effekt sich in der Zelle kollinear fortpflanzen.

3. Magnetometer nach Anspruch 2, wobei die Mittel zum Beleuchten der Zelle eine Anordnung von Fasern zum Aufrechterhalten der linearen Polarisation (15), in die das Pumpenstrahlenbündel und das Strahlenbündel mit dynamischem Stark-Effekt eingekoppelt werden, und einen Kollimator am Ausgang der Anordnung zum Kollimieren des Pumpenstrahlenbündels und des Strahlenbündels mit dynamischem Stark-Effekt in Richtung der Zelle umfassen.

4. Magnetometer nach Anspruch 3, wobei das Pumpenstrahlenbündel und das Strahlenbündel mit dynamischem Stark-Effekt in der Anordnung parallele Fortpflanzungsrichtungen aufweisen und die Polarisationsrichtungen zwischen ihnen einen Winkel von 45° bilden.

5. Magnetometer nach Anspruch 4, wobei die Mittel zum Beleuchten der Zelle des Weiteren eine zwischen den Kollimator und die Zelle eingesetzte Viertelwellenplatte (9) umfassen und von der die neutralen Achsen bei 45° von der linearen Polarisationsrichtung des Strahlenbündels mit dynamischem Stark-Effekt in der Anordnung vorliegen.

6. Magnetometer nach Anspruch 5, wobei der Polarisationsrotator (52) zwischen der Viertelwellenplatte (9) und der Zelle (1) interkaliert ist.

7. Magnetometer nach Anspruch 1, wobei das Pumpenstrahlenbündel und das Strahlenbündel mit dynamischem Stark-Effekt sich in der Zelle in umgekehrter Richtung fortpflanzen.

8. Magnetometer nach Anspruch 7, wobei das Pumpenstrahlenbündel und das Strahlenbündel mit dynamischem Stark-Effekt in der Zelle Fortpflanzungsrichtungen aufweisen, die zwischen ihnen einen von Null verschiedenen Winkel kleiner als 3° bilden.

9. Magnetometer nach einem der Ansprüche 1 bis 8, wobei der erste Modulator (6) zum Bewirken einer Intensitäts- oder der Polarisationsmodulation des Pumpenstrahlenbündels konfiguriert ist und die erste Modulationsfrequenz (fₘ₁) auf das Doppelte der Larmor-Frequenz geregelt ist.

10. Magnetometer nach einem der Ansprüche 1 bis 8, wobei der erste Modulator (6) zum Bewirken einer Wellenlängenmodulation des Pumpenstrahlenbündels konfiguriert ist.

11. Magnetometer nach Anspruch 10, wobei das Pumpenstrahlenbündel auf das Zentrum der Atomübergangslinie eingestellt ist und die erste Modulationsfrequenz (fₘ₁) auf die Larmor-Frequenz geregelt ist.

12. Magnetometer nach Anspruch 10, wobei das Pumpenstrahlenbündel auf mittlerer Höhe der Atomübergangslinie eingestellt ist und die erste Modulationsfrequenz (fₘ₁) auf das Doppelte der Larmor-Frequenz geregelt ist.

13. Magnetometer nach einem der Ansprüche 1 bis 12, wobei der zweite Modulator (10) zum Bewirken einer Intensitätsmodulation des Pumpenstrahlenbündels mit dynamischem Stark-Effekt konfiguriert ist und die zweite Modulationsfrequenz (fₘ₂) auf die Larmor-Frequenz geregelt ist.

14. Magnetometer nach einem der Ansprüche 1 bis 13, wobei der erste Regelschaltkreis (12) zum Durchführen einer synchronen Detektion bei der Larmor-Frequenz konfiguriert ist und
der zweite Regelschaltkreis (13) zum Durchführen einer synchronen Detektion bei dem Doppelten der Larmor-Frequenz konfiguriert ist.

## Claims

1. Optically-pumped magnetometer (10) intended to measure an ambient magnetic field, comprising:
means for illuminating a cell filled with an atomic gas with :
a pump beam (LP) tuned to an atomic transition line and and linearly polarised in a polarisation direction, and
an alternative Stark effect beam (LS) offset from the atomic transition line and polarised circularly,
a first modulator (6) configured to modulate the pump beam with a first modulation frequency (fₘ₁),
a polarisation rotator (52) configured to turn the polarisation direction of the pump beam,
a second modulator (10) configured to modulate the Stark effect beam with a second modulation frequency (fₘ₂),
a first servo circuit (12) acting on the polarisation rotator (52) in order to keep a constant angle (β) between the polarisation direction of the pump beam and the ambient magnetic field,
a second servo circuit (13) acting on the first and second modulator in order to keep the first and second modulation frequency at the Larmor frequency of the atomic gas or at one of the harmonics thereof.

2. Magnetometer according to claim 1, wherein the pump beam and the alternative Stark effect beam propagate collinearly in the cell.

3. Magnetometer according to claim 2, wherein said means for illuminating the cell comprise an assembly of linear polarisation maintenance fibres (15) in which the pump beam and the alternative Stark effect beam are injected and a collimator at the output of said assembly for collimating the pump beam and the alternative Stark effect beam in the direction of the cell.

4. Magnetometer according to claim 3, wherein the pump beam and the alternative Stark effect beam have in said assembly parallel propagation directions and polarisation directions forming an angle of 45° between them.

5. Magnetometer according to claim 4, wherein said means for illuminating the cell further comprise a quarter-wave plate (9) interposed between the collimator and the cell, neutral axes of the quarter-wave plate being at 45° from the linear polarisation direction of the alternative Stark effect beam in said assembly.

6. Magnetometer according to claim 5, wherein the polarisation rotator (52) is interposed between the quarter-wave plate (9) and the cell (1).

7. Magnetometer according to claim 1, wherein the pump beam and the alternative Stark effect beam propagate in opposite directions in the cell.

8. Magnetometer according to claim 7, wherein the pump beam and the alternative Stark effect beam have in the cell propagation directions forming between them a non-zero angle of less than 3°.

9. Magnetometer according to one of claims 1 to 8, wherein the first modulator (6) is configured to perform an intensity or polarisation modulation of the pump beam and the first modulation frequency (fₘ₁) is slaved to twice the Larmor frequency.

10. Magnetometer according to one of claims 1 to 8, wherein the first modulator (6) is configured to perform a wavelength modulation of the pump beam.

11. Magnetometer according to claim 10, wherein the pump beam is tuned to the centre of the atomic transition line and the first modulation frequency (fₘ₁) is slaved to the Larmor frequency.

12. Magnetometer according to claim 10, wherein the pump beam is tuned to half-way up the atomic transition line and the first modulation frequency (fₘ₁) is slaved to twice the Larmor frequency.

13. Magnetometer according to one of claims 1 to 12, wherein the second modulator (10) is configured to perform an intensity modulation of the alternative Stark effect beam and the second modulation frequency (fₘ₂) is slaved to the Larmor frequency.

14. Magnetometer according to one of claims 1 to 13, wherein the first servo circuit (12) is configured to perform a synchronous detection at the Larmor frequency and the second servo circuit (13) is configured to perform a synchronous detection at twice the Larmor frequency.
